Europäisches Patentamt

European Patent Office

Office européen des brevets

(11) Publication number: **0 214 628**
**B1**

# EUROPEAN PATENT SPECIFICATION

(45) Date of publication of the patent specification:
14.03.90

(51) Int. Cl.⁴: **H05K 7/06**

(21) Application number: **86112310.7**

(22) Date of filing: **05.09.86**

(54) Process for the manufacture of substrates to interconnect electronic components and articles made by said process.

(30) Priority: **13.09.85 US 775770**

(43) Date of publication of application:
**18.03.87 Bulletin 87/12**

(45) Publication of the grant of the patent:
**14.03.90 Bulletin 90/11**

(84) Designated Contracting States:
**DE FR GB IT NL SE**

(56) References cited:
**EP-A- 0 167 344**
**FR-A- 1 558 724**
**FR-A- 2 084 258**
**US-A- 3 674 602**

**PRODUCT ENGINEERING, vol. 47, no. 11,
November 1976, pages 48-52, New York, US: "The
printed circuit board is only one contender in the new
technology"**

(73) Proprietor: **KOLLMORGEN CORPORATION, 10 Mill Pond
Lane, Simsbury, CT 06070(US)**

(72) Inventor: **Lassen, Charles L., 50 Shore Road, Cold Spring
Harbor, NY 11724(US)**

(74) Representative: **Königseder-Egerer, Claudia D.,
Zugspitzstrasse 65, D-8104 Grainau(DE)**

## Description

This invention relates to substrates comprising printed circuit conductor patterns and wire scribed conductors suitable for supporting and interconnecting components and a method for making such substrates.

US Patents 3 674 602 and 3 674 914 disclose and describe wire scribed circuit boards and methods and apparatus for making such boards. In accordance with this prior art technology a wire is scribed onto and affixed to the surface of a panel in a predetermined pattern.

In the past, leads of components, e.g., of packages, commonly called dual-in-line packages, have been mounted onto and connected to wire scribed or printed circuit boards by inserting the leads into holes with metallized walls, commonly known as plated through holes. Extremely compact microelectronic packages have been developed to accommodate very complex integrated circuits. One such familiy of packages, commonly called chip carriers, may be surface mounted rather than being connected by leads passing through holes in the board. These packages are square and have terminals on all four edges rather than on two sides as in the dual-in-line packages. The terminals are spaced on centers of 1,27 mm (50 mils), 1,016 mm (40 mils) or less, thus substantially reducing the area of the packages as compared to the dual-in-line package. This substantially increases the number of terminals per unit area.

The reduction in package area made possible by the chip carrier substantially increases the number of microelectronic packages which may be mounted and electrically connected by an interconnection substrate of given area. However, such increase in number of packages or component package density and closer terminal spacing increases the terminal density requirements on the board or substrate and heat density of the system. This increased terminal density generates and requires higher conductor density. Contact pads, rather than through holes, are employed on the surface of the substrate for connecting such components to respective conductors. Electrical contact between such surface pads and the substrate conductors can be made in dimensions which approach that of the conductor itself thus leaving space for higher conductor density.

A process for scribing filaments onto a carrier in a predetermined pattern in a high density horizontal and vertical grid is described in US patent 4 500 389. The conductor filaments contain at least one conductive portion, e.g., an electrical conductor, an optical conductor or the like. The conductive portion of the filaments may or may not have a dielectric coating. The filaments are bonded to the carrier in a high density horizontal and vertical grid. A layer of coating material capable of being hardened at a temperature below 100°C is applied over the filaments forming a smooth, planar surface over the carrier and filaments. The coating material is then cured. The carrier is attached to a table movable in a controlled pattern along "X" and "Y" axes so as to locate preprogrammed points in the carrier under a high energy beam, such as a coherent laser (e.g. $CO_2$ or other suitable laser), controlled depth mechanical drills, a modulated stream of abrasive particles, a water jet or stream of chemicals or solvents.

The beam is directed perpendicular to the table and to the carrier mounted thereon. Alternatively, the carrier may be fixed and the beam moved in "X" and "Y" axes. The location of the filaments in the hardened, planar material are targeted optically so as to substantially eliminate location errors. The carrier is moved relative to the high energy beam so that the desired filament is in line with the beam at a predetermined point. The filament is then exposed by the beam at such point. If the filament is metallic, a high energy beam, such as a $CO_2$ laser, is used. The beam is aligned with the desired predetermined point on the filament, and then the beam is pulsed or modulated to direct energy at the filament so as to vaporize and remove the hardened material and the filament insulation, leaving a precisely formed cavity with the filament substantially exposed.

The impoved process of this invention provides even greater density and better electrical properties and enable the production of interconnection substrates which can accommodate high pin-count, high speed electronic packages. It further affords the electronics industry new ways in which to construct high-density interconnection circuits.

According to the process of this invention, the material which forms the core of the substrate base used should have good heat dissipation properties; it should be dimensionally stable and preferably have coefficients of thermal expansion in the X-, Y-plane which match the coefficient of thermal expansion of the chip carrier or other circuit component materials to be mounted on the substrate.

Another improvement over known processes is the sequential layering of circuit patterns which provide circuitry for two or more functions on one interconnection circuit board. Still another improvement is a process providing means for wiring a substrate base on both sides and providing side-to-side communications.

In accordance with the invention as claimed, there is provided a process for making substrates for mounting and interconnecting high density components comprising a substrate core, printed circuit conductor patterns and wire scribed conductors (hereinafter also referred to as 'interconnection circuit boards') comprising the steps of forming on said substrate core at least a first and a second printed circuit patterns electrically insulated from each other; forming at least a first cavity in predetermined locations penetrating said second pattern and substantially exposing said first pattern; providing interfacing means between the said circuit patterns for establishing electrical conduct between respective conductors of the first and second pattern; applying and affixing conductor filaments over said printed circuit patterns, said filaments comprising a conductive core, thus forming a wire scribed circuit pattern; applying a smooth, flat, planar coating over the surface provided with said wire scribed circuit pattern thus maintaining the position of the filaments and providing a surface suitable for mounting surface-mounted components; forming, at predetermined locations on said planar surface, at least a first cavity penetrating said coating and substantially exposing the conductive core of a respective conductor filament while maintaining the integrity of said wire scribed pattern; and providing conductive interfacing means between said core of said conductor filament and the external surface of said planar coating.

Fig. 1 is a perspective view with partial cut-away of an interconnection substrate made according to the process of this invention having a multiple-layer substrate core and plated through hole communication between both sides of the board.

Fig. 2 is a cross-sectional view of an interconnection circuit board having multiple levels of power and ground planes.

In the instant invention, a high density interconnection circuit may be formed and processed on a substrate core which will form an integral part of the article. Therefore, said substrate core must be selected from a material which is suitable for incorporation into said high density interconnection circuit and dimensionally stable for the process to be employed in its fabrication.

Preferably, the substrate core may be made of an alloy of nickel and iron comprising, e.g., between 55-65% iron and 30-35% nickel, and more preferably 57-60% iron and 40-43% nickel. The alloy sheet is preferably clad with a thin layer of conductive metal such as copper to provide improved thermal and electrical conductivity. The core may also be a thin laminate composed of a thin fiberglass-reinforced epoxy resin sheet bonded on both sides with composite metal sheets. The composite metal sheets themselves should have thin metal alloy cores of about 60-65% iron and 35-40% nickel clad with very thin copper sheets.

Also suitable for use as core materials are, e.g., copper/molybdenum alloys, polyimides and epoxy resins which may be reinforced with glass, quartz, Kevlar® or the like. Preferably, the coefficients of thermal expansion should be between 5 and 20 x $10^{-6}$ °C$^{-1}$. Some examples of possible core materials and their coefficients of thermal expansion (TCE) in the X-,Y-plane are shown in Table I.

Table 1

| Substrate Type | TCE (°C) |
|---|---|
| Alloy 42 (58% iron, 42% nickel) | $5.5 \times 10^{-6}$ |
| Cu-clad Invar (64% iron, 36% nickel) | $5\text{-}8 \times 10^{-6}$ |
| Cu/Mo Alloy | $6.0 \times 10^{-6}$ |
| Polyimide / Quartz | $7\text{-}9 \times 10^{-6}$ |
| Polyimide / Glass | $12 \times 10^{-6}$ |
| Polyimide / Kevlar® | $5\text{-}7 \times 10^{-6}$ |
| Epoxy / Kevlar® | $5\text{-}7 \times 10^{-6}$ |
| Epoxy / Glass | $12\text{-}16 \times 10^{-6}$ |

The present invention may be used to accommodate compact microelectronic packages. The interconnection circuit boards made in accordance to the process of this invention may take the form of certain preferred embodiments.

One preferred process of making the interconnection circuit boards according to the present invention is to apply thin copper foil to each side of a substrate core using a suitable dielectric bonding material. Circuit patterns should be formed on one or both of the copper foil surface(s) according to methods known to those skilled in the art. The substrate base should be treated so as to promote adhesion. The surface of the substrate base should then be encapsulated with a resin so as to obtain a flat, smooth, planar surface. The coating should be covered with an adhesive and the surface scribed with filaments, such as wire conductors. The formed wire scribed circuit pattern should then be encapsulated with resin to form a smooth, flat, planar surface and to provide a means for maintaining the positional relationship of the filaments. It should then be further coated with adhesive. The thus prepared substrate should be mounted on an X-, Y-positioning table and cavities formed at predetermined locations. The cavities should be cleaned and treated to promote subsequent metal plating. The substrate should then be plated with conductive material and circuit patterns should be formed in the conductive material according to methods known to those skilled in the art.

In another preferred embodiment, a sequence of layers may be produced which provide circuitry for two or more desired functions on one board. In this embodiment, conductive material should first be laminated to a substrate core using a dielectric bonding material. A circuit pattern should be formed on the resulting substrate base. The surface should be treated to promote adhesion. Thin sheets of conductive material should be laminated to the base such that the conductive material is isolated from the base and is on the external surface.

Additional circuit patterns can then be formed on the conductive material. The substrate base should then be placed on an X-, Y-positioning table for cavity formation between the two conductive layers in predetermined areas. The substrate base should then be plated to deposit conductive metal in the cavities. If desired, additional circuit layers may be formed over these layers in accordance with the process of this invention.

The substrate base is then treated as described hereinbefore including the steps of encapsulation, wire scribing, further encapsulation, cavities formation, metal plating and formation of circuit patterns according to methods known to those skilled in the art.

This embodiment provides for at least two circuit levels, which can be used for power and ground distribution, logical functions, or the like. Obviously, more than two or three circuit levels may be built on the substrate. Using the encapsulating method of this invention in order to maintain the position of the wires and thus enable the conductors to be scribed in high density, another embodiment may be produced. The substrate may be wired on both sides and provided with plated through holes in order to provide side-to-side communications between the sides of the circuit board. The conductors should be positionally stabilized with an encapsulation layer according to this invention to enable very close clearances. In this embodiment, one or more cavities may be made in addition to the through holes.

In the preferred embodiments of this invention, the dielectric substrate base is mounted on and affixed to a rigid stable base while the wire is scribed; the liquid coating is applied, levelled, flattened and cured in accordance with the teachings of US patent 3 607 380. The cavities in the circuit which are used to expose the wires or conductors are formed by high energy beams and the holes are electrolessly plated or electroplated.

In the preferred embodiments of this invention, the conductor or wire extends through the high energy formed cavity at the time of plating. This provides better electrical and mechanical strength between the conductor and cavity plating metal than could be achieved when attempting to drill through a 50,8 to 101,6 $\mu$m (2 to 4 mil) diameter wire with a 6 to 12 mil diameter drill.

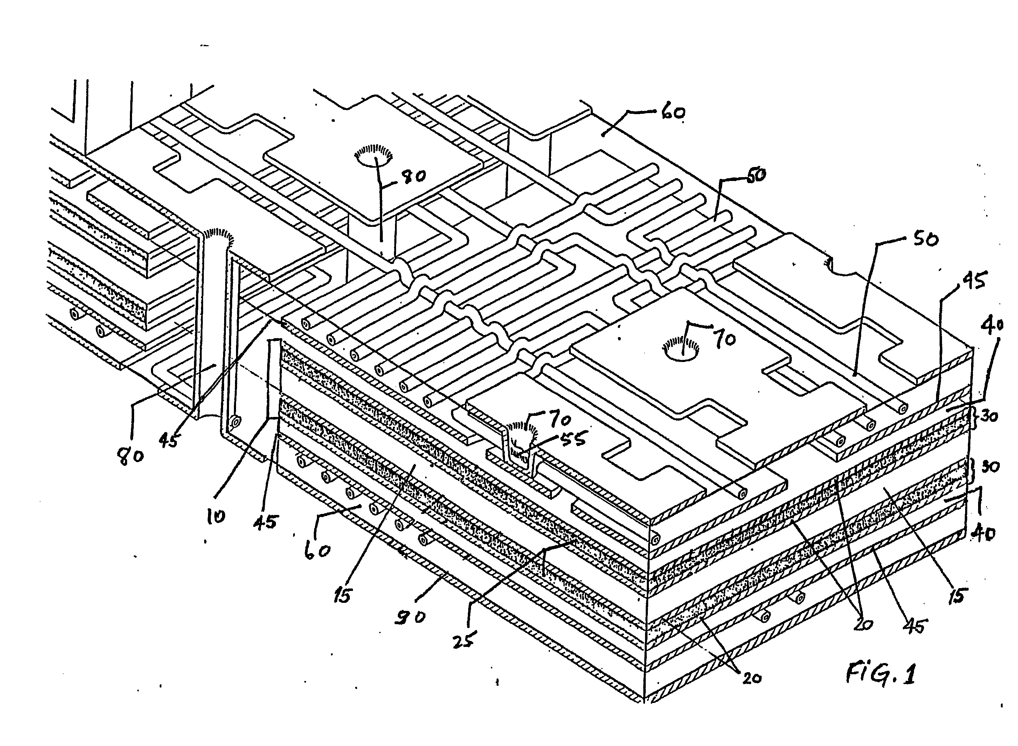

Fig. 1 depicts the substrate core 10, which is also described in Example 4 hereinafter. The substrate core 10 comprises an epoxy resin sheet 15 bonded on each side to composite metal sheets 30 consisting of very thin metal alloy cores 25 and cladding 20. The metal alloy is comprised of 64% iron and 36% nickel and the cladding material is copper.

A layer of flat planar coating 40 is placed over cladding 20. Over this coating layer 40 is laminated a copper sheet 45 to both sides of the structure. This copper sheet 45 is etched to form a desired pattern and wire filaments 50 are scribed in a predetermined pattern onto both sides of the base structure. A smooth, flat, planar coating 60 is applied over the entire surface comprising said filaments 50. Cavities 70 are made by exposing predetermined areas along the base structure to a $CO_2$ laser and oblating the smooth, flat, planar coating at those points. This procedure leaves the conductive core 55 of said filaments intact. At other predetermined points, holes 80 are drilled to afford communication between both sides of the interconnection circuit board. A copper layer 90 may be attached and surface patterns provided.

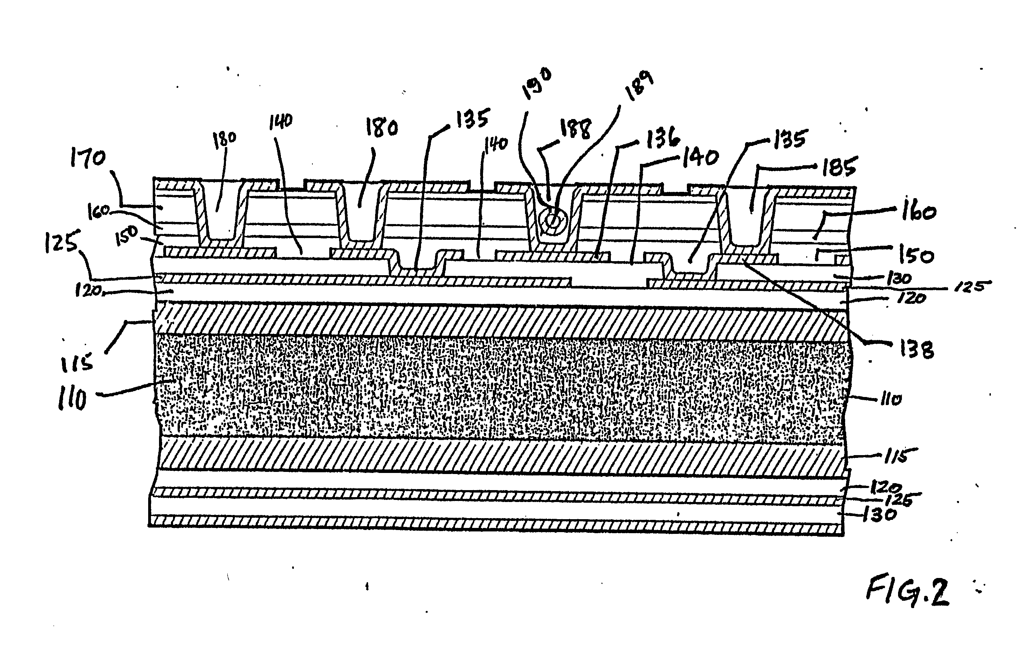

Fig. 2 is a cross-sectional view of an improved interconnection circuit board made in accordance with this invention. The substrate core comprises a support sheet 110 provided on both sides with copper foil 115 and an epoxy resin sheet 120.

A printed circuit conductor pattern 125 is formed on the surface of epoxy resin sheet 120 by known processes. The entire surface is provided with a smooth, flat, planar coating 130 thus encapsulating said conductor pattern 125. Coating 130 is cured and a circuit pattern 138 is formed on its surface, e.g., by first providing it with a copper cladding and subsequently removing it from areas 140 not representing circuit conductors. The formed laminate is exposed to a $CO_2$ laser in predetermined locations 135 thus forming a cavity at each such location exposing the respective areas of conductor pattern 125. Subsequently, metal is deposited in cavities 135 thus connecting respective conductors of patterns 125 and 136 or 138.

Next, the entire surface is encapsulated with a layer of resin 150 and wire filaments 160 are scribed onto the resulting resin surface in a predetermined pattern. Subsequently, filaments 160 of the scribed circuit pattern are encapsulated thus forming a smooth, flat, planar surface 170. Cavities 180 are formed in predetermined locations using a $CO_2$ laser and metallized thus providing connections between conductor level 125 and the external surface of the board by means of cavity 135 or cavities 135 and 185. Metallization of cavity 188 contacts conductor pad 136 and metal core of conductor wire 189 with plated overcoat 190.

In the practice of this invention cavity forming with a high energy beam , such as a laser, has been found to be particularly useful. However, other means such as a drill bit, abrasive, chemical or high speed jet might also be employed. Other high energy beams absorbable by the material being drilled, but not the conductor or wire, and capable of volatilizing the material and insulation on the conductor or wire, may also be employed. The following examples serve to illustrate certain preferred embodiments of this invention.

## EXAMPLE 1

A 0.45 mm thick metal alloy sheet core of 64% iron and 36% nickel was clad on both of its planar surfaces with copper metal sheets having a thickness of 0.15 mm. The copper surfaces were treated to form a black oxide layer suitable for promoting adhesion. The substrate base was laminated on each side with copper foil 0.035 mm thick and a semi-cured fiberglass-reinforced epoxy resin sheet. The lamination took place at a pressure of $2,585 \times 10^6$ Pa (375 psi) and 175°C for a period of 25 minutes. The substrate base was then baked at a temperature of 175°C for 1 hour in order to effect full curing of the epoxy resin.

After brushing the surface, a circuit pattern was formed on one side of the substrate by providing it with a dry film photoresist, exposing the resist layer to an UV light source through suitable artwork and developing thus forming an etching mask. The other side of the substrate base was encapsulated by photoresist material. The substrate base was then exposed to a ferric chloride-water solution to remove exposed copper metal from its surface. The remaining photoresist masking layer was removed from the surfaces and the substrate base treated to form a black oxide layer for adhesion promotion.

The patterned surface was then coated with an encapsulating resin according to the following procedure: A pair of rigid rollers, mounted parallel to each other, were adjusted to provide a controlled encapsulation thickness. A filled, thermosetting epoxy resin which cures at room temperature was thoroughly mixed with an amount of curing agent sufficient to ensure complete polymerization. This mixture was placed into a bell jar and the bell jar evacuated with a vacuum pump. The mixture was uniformly applied to the patterned surface of the substrate base. The substrate base was then placed in a vacuum chamber to remove any air in the mixture. After removal from the vacuum chamber, one edge of the substrate base was placed into the preset gap between the rigid rollers. One end of a 0.1 mm thick release-treated polyester carrier sheet on which was coated a 0.07 mm thick sheet of wiring adhesive was placed in contact with and parallel to the gap egde of the substrate base. The substrate base, carrier sheet and adhesive were then drawn through the gap in order to bond the adhesive to the resin surface such that the surface of the adhesive was substantially flat. The encapsulating resin was allowed to cure at room temperature for a period of 8 hours and subsequently baked for a period of 30 minutes at a temperature of 65°C. After baking, the substrate base was placed onto a computer-controlled X-, Y-positioning table with the adhesive-coated surface exposed and a wire scribed conductor pattern applied to it employing insulated copper wire 0.064 mm in diameter. The thus formed article was then baked for a period of 90 minutes at a temperature of 95°C and the wire scribed circuit pattern coated with an encapsulating resin coating and adhesive sheet to stabilize the position of the scribed wire and to form a flat, planar surface in accordance with the procedure described above. The adhesive sheet in this procedure was specifically adapted for processing using semi-additive plating techniques. It was 0.03 mm thick. After being drawn through the rollers, the substrate base was allowed to cure at room temperature for 8 hours and then baked at 65°C for 90 minutes.

The substrate base was then placed onto an X-, Y-positioning table with the adhesive surface exposed and the beam of a $CO_2$ laser was directed to the adhesive surface at predetermined locations. The laser beam vaporized and removed the materials surrounding the copper wire and formed cavities which were between 0.25 and 0.30 mm in diameter.

After baking in an oven for 30 minutes at a temperature of 120°C and for 90 minutes at 175°C, the surface was cleaned by an ultrasonically-agitated cleaning solution and rinsed in order to remove any dirt or debris from the laser-generated cavities. It was further cleaned by immersion for 40 minutes in a solution of potassium permanganate in water which was maintained at a pH of about 13.5, followed by immersion for 3 minutes in a stannous chloride and a dilute hydrochloric acid solution at room temperature. The substrate base was rinsed in running water for 6 minutes.

A palladium/tin catalyst was applied to the substrate surface to render it active for metal deposition and subsequently a very thin layer of copper metal was deposited by electroless deposition. After rinsing in running water for 60 seconds, the thin copper layer was enhanced by electroplating.

The surface was then brushed and coated with a dry film photoresist which was exposed and developed as described above to form a circuit pattern on the substrate base. It was then again electroplated in order to increase the thickness of the copper deposit in the areas not masked by the photoresist, rinsed in running water and immersed in a commercially available tin/lead electroplating solution in order to deposit solder on all exposed copper surfaces.

The photoresist was removed and the surfaces exposed to a copper etching solution which did not dissolve the tin/lead plating thus preserving the desired circuit pattern while all copper metal in areas not protected by the tin/lead overplate was dissolved and removed.

The thus formed article was rinsed in running water, baked for 30 minutes at 65°C and and additional 120 min. at 175°C. It was then subjected to conventional fabrication operations such as cutting to size and drilling mounting holes thus producing the finished wire-scribed circuit board suitable as the substrate for mounting and connecting high density components.

## EXAMPLE 2

The procedure of Example 1 was repeated up to and including the step of removing the photoresist masking layer from the surfaces and treating the substrate base to form a black oxide layer for adhesion promotion as described hereinbefore.

Subsequently, thin, single-sided copper-clad laminated sheets were applied to each side of the substrate base by a lamination step employing semi-cured fiberglass reinforced epoxy sheets as the bonding medium.

Circuit patterns were formed on the substrate base as described above in Example 1, except that they consisted of circular pad areas of between 0.2 and 0.25 mm in diameter. In predetermined locations, the cured epoxy resin layer was evaporated and thus removed between the two copper layers using a $CO_2$ laser as in Example 1. After cleaning and rinsing, the surface was rendered receptive to metal deposition using a palladium/tin solution, immersed in an acidic copper sulfate plating solution and electroplated to deposit copper metal in the said cavities. Subsequently, the substrate was removed from the solution, rinsed in running water for 2 minutes, dried and the surface provided with an encapsulated, wire scribed conductor pattern and processed in accordance with Example 1.

EXAMPLE 3

The procedure of Example 1 were followed except that the metal alloy sheet used as the core was composed of 58% iron and 42% nickel, and it was not clad with copper metal sheets. Mechanical roughening techniques were employed in order to promote adhesion.

EXAMPLE 4

The procedures of Example 2 were followed except that the metal alloy core was replaced by a thin laminate consisting of a 0.127 mm thick fiberglass reinforced epoxy resin sheet bonded on each side with composite metal sheets consisting of 0.12 mm thick metal alloy cores (64% iron and 36% nickel) both sides of which were clad with 0.02 mm thick copper metal.

EXAMPLE 5

A metal alloy core comprising 64% iron and 36% nickel and being 0.15 mm thick was clad on both surfaces with copper metal sheets having a thickness of 0.05 mm each. The clad metal alloy core was placed onto an X-, Y-positioning table, the table moved to perdetermined locations, and 1.07 mm diameter holes were mechanically drilled through the core.

The copper surfaces of the drilled metal alloy sheet were treated to promote adhesion by exposure to a commercially available treatment solution for producing a black oxide layer.

Several sheets of semi-cured fiberglass reinforced epoxy resin were laminated to the thus prepared surfaces thus filling the drilled holes, and a sheet of copper foil 0.035 mm thick was laminated to wach side as desscribed in Example 1.The resulting laminate was baked for 60 minutes at a temperature of 175°C to fully cure the epoxy resin.

After cleaning, a dry film photoresist was applied to each side, exposed through a master and developed in order to form circuit pattern masks.

The substrate was then exposed to ferric chloride solution as described in Example 1 to dissolve copper metal in areas not protected by said mask. Subsequently, the remaining photoresist material was removed and the copper surface provided with a black oxide layer.

The substrate was then provided with resin and adhesive layers and scribed with wire, one side at a time, according to the procedures of Example 1, then provided with holes in the same locations in which holes were drilled earlier, said holes having a diameter of 0.5 mm and being produced by mechanical drilling through the layers on the substrate base.

The substrate was then subjected to the cleaning/adhesion promotion treatment and plated in accordance with the process described in Example 1.

**Claims**

1. A process for making substrates for mounting and interconnecting high density components comprising a substrate core (10, 110, 115, 120), printed circuit conductor patterns (45, 90, 125, 138) and wire scribed conductors, characterized in that it comprises the steps of
- forming on said substrate core at least a first (45, 125) and a second (90, 138) printed circuit pattern electrically insulated from each other;
- forming at least a first cavity in predetermined locations penetrating said second pattern and substantially exposing said first pattern;
- providing interfacing means between the said circuit patterns for establishing electrical conduction between respective conductors of the first and second pattern;
- applying and affixing conductor filaments (50, 160) over said printed circuit patterns, said filaments comprising a conductive core, thus forming a wire scribed circuit pattern;
- applying a smooth, flat, planar coating (60, 170) over the surface provided with said wire scribed circuit

6

pattern thus maintaining the position of the filaments and providing a surface suitable for mounting surface-mounted components;

- forming, at predetermined locations on said planar coating, at least a second cavity penetrating said planar coating and substantially exposing the conductive core of a respective conductor filament while maintaining the integrity of said wire scribed pattern; and

- providing conductive interfacing means between said core of said conductor filament and the external surface of said planar coating.

2. The process of claim 1 wherein said interfacing means is a metal deposit.

3. The process of claim 2 wherein said metal deposit is formed by a metal plating operation.

4. The process of claim 1 wherein said substrate core is, or is provided with, an additional core layer which is dimensionally stable.

5. The process of claim 1 wherein the coefficient of thermal expansion of said substrate core substantially matches the coefficient of thermal expansion of the components which are to be mounted on its surface.

6. The process of claim 1 wherein the coefficient of thermal expansion of said substrate core is between 5 and 20 x $10^{-6}$ °C$^{-1}$.

7. The process of claims 1 to 6 further comprising the step of providing, at a predetermined location, at least one through hole intersecting at least one of the conductors and having metallized walls.

8. The process of claim 1 wherein said substrate core comprises an epoxy resin impregnated core sheet which is provided on both sides with a metal alloy sheet comprising between 60 and 65% iron and between 35 and 40% nickel, the surface of said alloy sheets being clad with copper.

**Patentansprüche**

1. Verfahren zum Herstellen von Basisplatten für die Montage und das Verbinden von Bauteilen in geringen Abständen voneinander, bestehend aus einer Kernplatte (10, 110, 115, 120), gedruckten Leiterzugmustern (45, 90, 125, 138) und drahtgeschriebenen Leitern, dadurch gekennzeichnet, daß es die folgenden Schritte aufweist:

- Herstellen mindestens eines ersten (45, 125) und eines zweiten (90, 138), elektrisch voneinander isolierten, gedruckten Leiterzugmusters auf der Kernplatte;

- Herstellen mindestens einer ersten Vertiefung in vorbestimmten Bezirken, die das zweite Leiterzugmuster durchdringt und das erste Leiterzugmuster praktisch völlig freilegt;

- Anbringen von Verbindungselementen zwischen den genannten Leiterzugmustern zum Aufbau von elektrischen Kontakten zwischen bestimmten Leitern des ersten und des zweiten Leiterzugmusters;

- Auflegen und Verankern von mit einem elektrisch leitenden Kern versehenen Drahtleiterzügen (50, 160) über den genannten gedruckten Leiterzugmustern, wodurch ein drahtgeschriebenes Leiterzugmuster hergestellt wird;

- Aufbringen einer glatten, flachen, ebenen Überzugschicht (60, 170) auf der mit dem drahtgeschriebenen Leiterzugmuster versehenen Oberfläche, wodurch die Position der Drahtleiterzüge aufrechterhalten und eine Oberfläche geschaffen wird, auf der Oberflächen-montierte Bauteile angebracht werden können;

- Herstellen mindestens einer zweiten Vertiefung in vorbestimmten Bezirken auf der ebenen Überzugschicht, die diese durchdringt und den elektrisch leitenden Kern eines entsprechenden Drahtleiterzuges praktisch völlig freilegt, unter Aufrechterhaltung der Integrität des drahtgeschriebenen Leiterzugmusters; und

- Anbringen von elektrisch leitenden Verbindungselementen zwischen dem genannten Kern des Drahtleiterzuges und der äußeren Oberfläche der genannten ebenen Überzugschicht.

2. Verfahren nach Anspruch 1, dadurch gekennzeichnet, daß das Verbindungselement eine Metallschicht ist.

3. Verfahren nach Anspruch 2, dadurch gekennzeichnet, daß die Metallschicht in einem Metallabscheidungsverfahren hergestellt wird.

4. Verfahren nach Anspruch 1, dadurch gekennzeichnet, daß die genannte Kernplatte selbst eine zusätzliche Kernschicht oder mit einer solchen versehen ist, die dimensionsstabil ist.

5. Verfahren nach Anspruch 1, dadurch gekennzeichnet, daß der Wärmeausdehnungs-Koeffizient der genannten Kernplatte praktisch mit demjenigen der auf seiner Oberfläche anzubringenden Bauteile identisch ist.

6. Verfahren nach Anspruch 1, dadurch gekennzeichnet, daß der Wärmeausdehnungs-Koeffizient der genannten Kernplatte zwischen 5 und 20 x $10^{-6}$ °C$^{-1}$ beträgt.

7. Verfahren nach den Ansprüchen 1 bis 6, dadurch gekennzeichnet, daß dieses als weiteren Schritt das Anbringen mindestens eines durchgehenden Loches an einer vorbestimmten Stelle aufweist, welches mindestens einen der Leiterzüge durchdringt und metallisierte Lochwandungen aufweist.

8. Verfahren nach Anspruch 1, dadurch gekennzeichnet, daß die genannte Kernplatte eine mit Epoxyharz getränkte Kernschicht aufweist, die auf beiden Seiten mit einem Metallbelag versehen ist, der aus einer Legierung von zwischen 60 und 65% Eisen und zwischen 35 und 40% Nickel besteht, und dessen Oberflächen mit einer Kupferschicht kaschiert sind.

**Revendications**

1 - Procédé pour fabriquer des substrats pour le montage et l'interconnexion de composants à haute densité comportant une partie centrale (10, 110, 115, 120) de substrat, des motifs (45, 90, 125, 138) de conducteurs de circuits imprimés et des conducteurs tracés en fils, caractérisé en ce qu'il comprend les étapes consistant à :
- former sur la partie centrale du substrat au moins des premier (45, 125) et second (90, 138) motifs à circuits imprimés isolés électriquement l'un de l'autre;
- former au moins une première cavité dans des emplacements prédéterminés pénétrant le second motif et exposant sensiblement ce premier motif;
- fournir un moyen d'interface entre les motifs des circuits pour établir une conduction électrique entre des conducteurs respectifs des premier et second motifs;
- appliquer et fixer des filaments (50, 160) de conducteurs sur les motifs des circuits imprimés, les filaments comportant une âme conductrice, formant ainsi un motif de circuits tracés en fils;
- appliquer un revêtement plan, plat, régulier (60, 170) sur la surface comportant le motif des circuits tracés en fils, maintenant ainsi la position des filaments et fournissant une surface appropriée pour le montage de composants montés en surface;
- former, à des emplacements prédéterminés du revêtement plan, au moins une seconde cavité pénétrant le revêtement plan et exposant sensiblement l'âme conductrice d'un filament de conducteur respectif tout en maintenant l'intégrité du motif tracé en fils; et
- fournir un moyen d'interface conducteur entre l'âme du filament de conducteur et la surface extérieure du revêtement plan.

2 - Procédé selon la revendication 1, dans lequel le moyen d'interface est un dépôt métallique.

3 - Procédé selon la revendication 2, dans lequel le dépôt métallique est formé par une opération de revêtement avec un métal.

4 - Procédé selon la revendication 1, dans lequel la partie centrale du substrat est, ou comporte, une couche supplémentaire de partie centrale qui est dimensionnellement stable.

5 - Procédé selon la revendication 1, dans lequel le coefficient de dilatation thermique de la partie centrale du substrat est sensiblement adapté au coefficient de dilatation thermique des composants qui doivent être montés sur sa surface.

6 - Procédé selon la revendication 1, dans lequel le coefficient de dilatation thermique de la partie centrale du substrat est compris entre 5 et 20 x $10^{-6}°C^{-1}$.

7 - Procédé selon les revendications 1 à 6, comprenant en outre l'étape consistant à fournir, à un emplacement prédéterminé, au moins un trou traversant coupant au moins l'un des conducteurs et présentant des parois métallisées.

8 - Procédé selon la revendication 1, dans lequel la partie centrale du substrat comprend une feuille de partie centrale imprégnée de résine époxy qui est munie sur les deux côtés d'une feuille d'alliage métallique comprenant entre 60 et 65 % de fer et entre 35 et 40 % de nickel, la surface des feuilles d'alliage étant plaquée de cuivre.

FIG.1

FIG.2

EP 0 214 628 B1